# EUROPEAN PATENT APPLICATION

(11) **EP 2 711 972 A1**
(43) Date of publication of application: **26.03.2014**
(21) Application number: 12790206.2
(22) Date of filing: 16.05.2012
(51) Int. Cl.: H01L 21/027, H01L 21/205, H01L 21/3205, H01L 21/768

(54) **METHOD FOR MANUFACTURING PATTERN STRUCTURE**

(30) Priority: 20.05.2011 JP 2011113677; 18.10.2011 JP 2011229082
(71) Applicant: Sumitomo Corporation, Tokyo 104-8610 (JP)
(72) Inventor: MIYAGAWA Takashi, Tokyo 104-8610 (JP); MURAKAMI Tetsuya, Tokyo 104-8610 (JP); OKAMOTO Kimiyasu, Tokyo 104-8610 (JP)
(74) Representative: Piotrowicz, Pawel Jan Andrzej
(86) International application number: PCT/JP2012/062530
(87) International publication number: WO 2012/161051

(57) **Abstract**

A method for manufacturing a pattern structure includes the steps of forming a lift-off material on a base by an inkjet technique, forming a functional film on the base and the lift-off material by atomic layer deposition, and removing the lift-off material by a lift-off technique so as to form a pattern on the base from the functional film.

## Description

### Technical Field

The present invention relates to a method for manufacturing a pattern structure.

### Background Art

There have been known methods (see Patent Literatures 1 to 4) which form a thin film on a resist pattern by using atomic layer deposition (ALD) and then remove the resist pattern by using a lift-off technique, so as to produce a pattern. Such a method applies a resist onto a substrate and then exposes the resist to light and develops it, so as to form a resist pattern.

### Citation List

### Patent Literature

Patent Literature 1: Japanese Patent Application Laid-Open No. 2011-40656
Patent Literature 2: Japanese Patent Application Laid-Open No. 2009-157977
Patent Literature 3: Japanese Patent Application Laid-Open No. 2007-335727
Patent Literature 4: Japanese Patent Application Laid-Open No. 2008-547150

### Summary of Invention

### Technical Problem

When forming a resist pattern by using typical photolithography methods as in the above-mentioned Patent Literatures 1 to 4, however, the substrate is subjected to a high temperature process. This makes it difficult to use heat-susceptible bases such as polymer films, for example. The typical lithography methods also necessitate expensive devices such as steppers and elongate processes, thereby increasing the cost for forming the pattern.

The atomic layer deposition has recently been in use more and more because it is an excellent technique as a method for making gate insulators of semiconductor devices. However, since the lift-off technique is hard to employ, the pattern is typically produced by etching after forming a thin film by the atomic layer deposition. This is because materials deposited by the atomic layer deposition are likely to adhere to side walls of the resist pattern, so that the deposited film on the substrate and the deposit on the resist pattern may combine with each other, thereby making it hard for the resist pattern to peel off. That is also because the surface of the resist pattern is covered with the deposited film, whereby a solvent for peeling the resist pattern does not infiltrate well into the resist pattern.

In view of the circumstances mentioned above, it is an object of the present invention to provide a method for manufacturing a pattern structure which can form a pattern at low temperature and low cost and easily perform the lift-off.

### Solution to Problem

For achieving the above-mentioned object, the method for manufacturing a pattern structure in accordance with one aspect of the present invention comprises the steps of forming a lift-off material on a base by an inkjet technique, forming a functional film on the base and the lift-off material by atomic layer deposition, and removing the lift-off material by a lift-off technique so as to form a pattern on the base from the functional film.

This method can form a pattern on a base at low temperature and low cost by using the inkjet technique, atomic layer deposition, and lift-off technique, which enable low-temperature and low-cost processes and easily perform the lift-off. For example, as compared with typical photolithography techniques, the inkjet technique can form the lift-off material at lower temperature and lower cost and is easier to perform the lift-off. The atomic layer deposition can form the functional film at lower temperature than typical film-forming techniques do. The lift-off technique can form the pattern at lower temperature and lower cost than the typical photolithography techniques do.

In general, the inkjet technique tends to be used for forming patterns with lower dimensional accuracy than the typical photolithography techniques do. The inkjet technique forms a thicker material on the base, whereby irregularities on micron order are likely to occur on the material surface. This makes it hard to combine the atomic layer deposition, which requires high dimensional accuracy, with the inkjet technique. The material formed on the base by the inkjet technique is usually employed for some use and is not purposely removed by using the lift-off technique.

Using the lift-off material formed by the inkjet technique facilitates the lift-off. This is because, as compared with the other forming methods, the inkjet technique can use ink with a greater amount of a solvent or with a nonuniform solvent, for example, thereby being able to control the surface form of the film after its formation. Irregularities can be formed on the surface of the lift-off material depending on control. Forming the irregularities on the surface of the lift-off material facilitates the lift-off even when the surface of the lift-off material is covered with a deposited film having a favorable film forming property by the atomic layer deposition.

The lift-off material may be formed by applying ink containing a resin and a solvent onto the base and then removing the solvent.

The inkjet technique can use nonuniform solvents and dispersive solvents. It can control the surface form of the lift-off material by adjusting the composition of the ink according to the kind of the lift-off material.

The solvent may include a first solvent having a first solubility for the resin and a second solvent having a second solubility lower than the first solubility. The first solvent may be compatible with the second solvent. Alternatively, the solvent may include a third solvent compatible with the first and second solvents.

For example, the solvent contained in the ink may include the first solvent (e.g., an aqueous solvent or alcoholic solvent) having the first solubility for the resin and the second solvent (e.g., an alkylene glycol or alkyl ether) having the second solubility lower than the first solubility. In this case, the first solvent is compatible with the second solvent. For example, the resin may dissolve in the first solvent but not in the second solvent. For example, when the first solvent has a boiling point lower than that of the second solvent, the first solvent volatilizes earlier than the second solvent. As a result, the resin is deposited, whereby the formed lift-off material can have greater surface roughness. The mixing ratio of the first and second solvents can be determined according to the kind of the resin.

Alternatively, for example, the solvent contained in the ink may include the first solvent (e.g., water) having the first solubility for the resin, the second solvent (e.g., an organic solvent such as toluene) having the second solubility lower than the first solubility, and the third solvent (e.g., acetone) compatible with the first and second solvents. In this case, it is not necessary for the second solvent to be compatible with the first solvent. For example, the resin may dissolve in the first solvent but not in the second solvent. When the third solvent has a boiling point lower than those of the first and second solvents, the third solvent volatilizes earlier than them. As a result, the first and second solvents are separated from each other, whereby the formed lift-off material can have greater surface roughness. The mixing ratio of the first, second, and third solvents can be determined according to the kind of the resin.

Examples of the resin for use include polyvinyl acetal, polyvinylpyrrolidone, vinyl acetate/vinyl pyrrolidone copolymers, and polyacrylamides. Preferred in particular among them are polyvinyl acetal and vinyl acetate/vinyl pyrrolidone copolymers. Examples of the solvents for use include water, aqueous organic solvents, and organic solvents compatible with the aqueous organic solvents. Their examples include water, alcohols, glycols, polyhydric alcohols, ketones, pyrrolidones, glycol ethers, glycol diethers, alkylene glycols, alkyl ethers, and their mixed solvents.

The lift-off material may be made of a noncurable resin. This makes it possible to form the lift-off material at low temperature by volatilizing the solvent without curing it. The glass transition temperature (Tg) of the resin is 100°C or lower, for example. In this case, heating the lift-off material to the glass transition temperature (Tg) of the resin or higher mitigates stresses on the surface of the lift-off material, thereby changing the surface form. As a result, the lift-off becomes further easier.

The base may have a projection, and the lift-off material may be formed on the projection. For forming the lift-off material on the projection by the typical photolithography technique, it is necessary for a resist film formed on the base to have a flat surface. By contrast, the inkjet technique can form the lift-off material selectively at desirable locations, thereby eliminating the flattening process such as that of the typical photolithography technique and lowering the cost.

The projection may extend in a first direction along a surface of the base, while the lift-off material may be formed so as to extend in a second direction intersecting the first direction along the surface of the base. When forming the lift-off material by the typical photolithography technique, a gap may occur along the first direction between the base and the lift-off material at a skirt of the projection. By contrast, forming the lift-off material by the inkjet technique inhibits such a gap from occurring.

The base may be a polymer film. The polymer film can be used in low-temperature processes. As a result, various devices and flexible printed circuit boards (FPC) can be manufactured at low cost.

The lift-off material may be soluble in a solvent. In this case, the lift-off material can be removed easily by the solvent. The solvent may be any of water and organic solvents. The lift-off material may be made of a material requiring no curing process. The lift-off material may contain a resin and a solvent.

The lift-off material may be removed by using at least one of a solvent, an ultrasonic wave, water jetting, dry ice blasting, and a difference between coefficients of thermal expansion of the lift-off material and the base. When the difference between coefficients of thermal expansion of the lift-off material and the base is used, the lift-off material may be solubilized by heat or light (e.g., UV rays), so as to be removed.

After forming the pattern, the method may return to the step of forming the lift-off material. This repeatedly forms the pattern and thus can stack a plurality of patterns on the base.

### Advantageous Effects of Invention

The present invention provides a method for manufacturing a pattern structure which can form a pattern at low temperature and low cost and easily perform the lift-off.

### Brief Description of Drawings

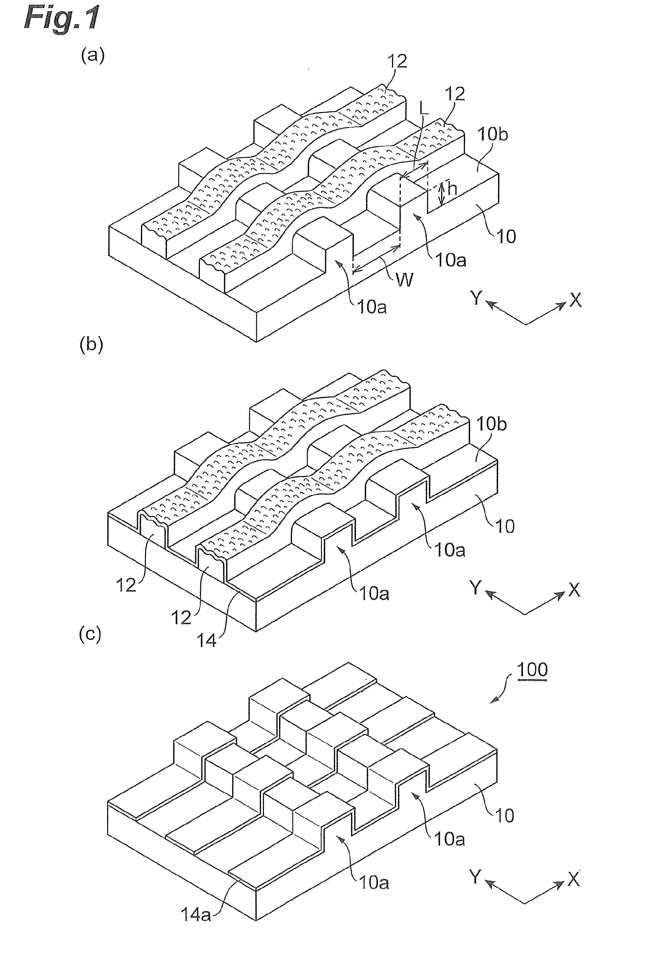

Fig. 1 is a set of diagrams schematically illustrating respective steps of the method for manufacturing a pattern structure in accordance with an embodiment.

### Description of Embodiments

In the following, embodiments of the present invention will be explained in detail with reference to the accompanying drawings. In the explanation of the drawings, the same or equivalent constituents will be referred to with the same signs while omitting their overlapping descriptions.

Fig. 1 is a set of diagrams schematically illustrating respective steps of the method for manufacturing a pattern structure in accordance with an embodiment. The method for manufacturing a pattern structure in accordance with this embodiment is performed as follows, for example.

### Lift-off material forming step

First, as illustrated in Fig. 1(a), lift-off materials 12 are formed on a base 10 by an inkjet technique. The base 10 may have projections 10a. The lift-off materials 12 may be formed on the projections 10a. The projections 10a extend in a first direction Y along a surface 10b of the base 10. The lift-off materials 12 may be formed so as to extend in a second direction X intersecting the first direction Y along the surface 10b of the base 10. The first direction Y may be orthogonal to the second direction X. The cross section of the lift-off material 12 in a plane perpendicular to the second direction X is semicircular, for example, but not limited thereto. The cross section of the projection 10a in a plane perpendicular to the first direction Y is rectangular, for example, but not limited thereto. The projection 10a may be formed either integrally with or separately from the base 10. Letting L and h be the width and height of the projection 10a, respectively, h/L may be 100 or less or 10 or less. Letting W be the distance between the projections 10a adjacent to each other, W/h may be 100 or less or 10 or less.

Examples of the base 10 include glass substrates, silicon substrates, polymer films, flexible bases, and their combinations. Polymer films can be used as the base 10 in low-temperature processes. As a result, for example, flexible printed circuit boards (FPC) can be manufactured at low cost. Examples of the base 10 include thermosetting films such as polyimide films, thermoplastic resin films such as polypropylene films, and transparent polyester bases.

The lift-off materials 12 may dissolve in a solvent. In this case, the lift-off materials 12 can be removed easily by the solvent. Examples of the solvent include water and organic solvents. The lift-off materials 12 may be made of any of resins based on celluloses (carboxyl cellulose and hydroxyethyl cellulose) and synthetic polymers (sodium polyacrylate, polyacrylamide, polyvinyl alcohol, polyethyleneimine, polyethylene oxide, and polyvinylpyrrolidone). The lift-off materials 12 may be made of a material which requires no curing process. The height of lift-off materials 12 from the surface 10b of the base 10 is 10 nm to 10 µm, for example. The lift-off materials 12 are formed by applying ink containing a resin and a solvent onto the base 10 and then removing the solvent by drying, for example. As a result, irregularities are formed on surfaces of the lift-off materials 12. The height of the irregularities can be controlled by the kind of the solvent and the mixing ratio of the resin and the solvent.

### Film forming step

Next, as illustrated in Fig. 1(b), a functional film 14 is formed on the base 10 and lift-off materials 12 by atomic layer deposition. First, for example, a first material for the functional film 14 is supplied onto the base 10 and lift-off materials 12, and then a purge gas is fed thereto. Subsequently, a second material such as an oxidizing agent, for example, is supplied onto the base 10 and lift-off materials 12, and then a purge gas is fed thereto. Repeating such a cycle forms the functional film 14.

Using the atomic layer deposition can enhance the uniformity in thickness of the functional film 14 in a wide area and form the functional film 14 with a stoichiometric composition having three-dimensional conformality. The thickness of the functional film 14 can also be controlled highly accurately. Even when dust particles exist, the functional film 14 is formed behind the dust particles and thus is relatively hard to be influenced by the dust particles.

Examples of the functional film 14 include conductor films, semiconductor films, insulating films, inorganic films, organic films, nano-multilayer films, composite oxide films, metal oxide films, and their combinations. When the functional film 14 contains a metal, examples of the metal include aluminum, copper, hafnium, ruthenium, tantalum, titanium, tungsten, zinc, and zirconium. As the first material for the functional film 14, any of TMA (Al(CH₃)₃), TDMAH (Hf[N(CH₃)₂]₄), Ru(C₅H₄-C₂H₅)₂, (CH₃)₃CN=Ta(N(C₂H₅)₂)₃, TDMAT (Ti[N(CH₃)₂]₄), ((CH₃)₃CN)₂W(N(CH₃)₂)₂, Zn(C₂H₅)₂, TDMAZ (Zr[N(CH₃)₂]₄), and the like may be used. The functional film 14 may also be an ITO film. The functional film 14 may also be a passivation film made of SiO₂, Al₂O₃, or the like, for example. The functional film 14 may also be a conductor film made of a ZnO semiconductor, an IGZO semiconductor, or the like, for example.

### Pattern forming step

Next, as illustrated in Fig. 1(c), the lift-off materials 12 are removed by the lift-off technique, so as to form a pattern 14a from the functional film 14 on the base 10. This manufactures a pattern structure 100. The lift-off materials 12 may be removed by using at least one of a solvent, an ultrasonic wave, water jetting, dry ice blasting, and a difference between coefficients of thermal expansion of the lift-off materials 12 and base 10. When the difference between coefficients of thermal expansion of the lift-off materials 12 and base 10 is used, the lift-off materials 12 may be solubilized by heat or light (e.g., UV rays), so as to be removed. After forming the pattern 14a, the method may return to the lift-off material forming step. Thus repeating the pattern formation can stack a plurality of patterns 14a on the base 10. The plurality of patterns 14a may differ from each other. The patterns 14a may be wiring patterns.

Examples of the pattern structure 100 include integrated circuits, displays, solar cells, imaging devices, sensors, semiconductor devices, electronic devices, optical devices, organic EL elements, inorganic EL elements, thin-film transistors (TFT), shift registers, printed circuit boards, flexible printed circuit boards (FPC), and their combinations. The FPC may use a transparent polyester base as the base 10, bit line leads as the pattern 14a, and word line circuit leads formed by an inkjet or screen printing technique, for example. In the case of the TFT, the pattern structure 100 may further comprise a shift register, while the base 10 may have a large area with a width of 300 mm or greater and a length of 2000 mm or greater. The organic EL element may use an organic EL layer as the pattern 14a.

The method for manufacturing a pattern structure in accordance with this embodiment can form the pattern 14a on the base 10 at low temperature and low cost by using the inkjet technique, atomic layer deposition, and lift-off technique, which enable low-temperature and low-cost processes and easily perform the lift-off. For example, as compared with typical photolithography techniques, the inkjet technique can form the lift-off materials 12 at lower temperature and lower cost and is easier to perform the lift-off. The atomic layer deposition can form the functional film 14 at lower temperature (e.g., room temperature to 400°C) than typical film-forming techniques do. The lift-off technique can form the pattern 14a at lower temperature and lower cost than the typical photolithography techniques do. Therefore, the base 10 (e.g., polymer film), which is likely to be damaged by heat, can be used. The pattern structure 100 can be manufactured by the lift-off technique, which is hard to be employed in the typical atomic layer deposition.

The method for manufacturing a pattern structure in accordance with this embodiment does not require processes such as exposure and thus is simpler in process, can form patterns by larger areas, and incurs lower cost as compared with the typical photolithography techniques. For example, the inkjet technique can form patterns by large areas. For example, the lift-off technique can cut down the manufacturing cost. Further, the atomic layer deposition can perform processes at low pressure and thus enables continuous processes with the inkjet technique and lift-off technique. It also enables a so-called roll-to-roll process which forms a roll by winding the base 10.

For forming the lift-off materials 12 on the projections 10a by the typical photolithography technique, it is necessary for a resist film formed on the base 10 to have a flat surface. By contrast, the inkjet technique can form the lift-off materials 12 selectively at desirable locations, thereby eliminating the flattening process such as that of the typical photolithography technique.

When forming the lift-off materials 12 by the typical photolithography technique, a gap may occur along the first direction Y between the base 10 and lift-off material 12 at a skirt of the projection 10a. By contrast, forming the lift-off materials 12 by the inkjet technique inhibits such a gap from occurring.

While a preferred embodiment of the present invention is explained in detail in the foregoing, the present invention is not limited thereto. For example, the base 10 may have the flat surface 10b without the projections 10a.

### Reference Signs List

10...base; 10a...projection; 10b... surface of the base; 12...lift-off material; 14...functional film; 14a...pattern; 100...pattern structure; X...second direction; Y...first direction

## Claims

1. A method for manufacturing a pattern structure, the method comprising the steps of:
forming a lift-off material on a base by an inkjet technique;
forming a functional film on the base and the lift-off material by atomic layer deposition; and
removing the lift-off material by a lift-off technique so as to form a pattern on the base from the functional film.

2. A method for manufacturing the pattern structure according to claim 1, wherein the lift-off material is formed by applying ink containing a resin and a solvent onto the base and then removing the solvent.

3. The method for manufacturing the pattern structure according to claim 2, wherein the solvent includes a first solvent having a first solubility for the resin and a second solvent having a second solubility lower than the first solubility.

4. The method for manufacturing the pattern structure according to claim 3, wherein the first solvent is compatible with the second solvent.

5. The method for manufacturing the pattern structure according to claim 3, wherein the solvent further includes a third solvent compatible with the first and second solvents.

6. The method for manufacturing the pattern structure according to one of claims 1 to 5, wherein the base has a projection; and
wherein the lift-off material is formed on the projection.

7. The method for manufacturing the pattern structure according to claim 6, wherein the projection extends in a first direction along a surface of the base; and
wherein the lift-off material is formed so as to extend in a second direction intersecting the first direction along the surface of the base.

8. The method for manufacturing the pattern structure according to one of claims 1 to 7, wherein the base is a polymer film.

9. The method for manufacturing the pattern structure according to one of claims 1 to 8, wherein the lift-off material is soluble in a solvent.

10. The method for manufacturing the pattern structure according to one of claims 1 to 9, wherein the lift-off material is removed by using at least one of a solvent, an ultrasonic wave, water jetting, dry ice blasting, and a difference between coefficients of thermal expansion of the lift-off material and the base.

11. The method for manufacturing the pattern structure according to one of claims 1 to 10, wherein the method returns to the step of forming the lift-off material after forming the pattern.
